Europäisches Patentamt

European Patent Office

Office européen des brevets

(19)

(11) Publication number: **0 115 504**
**B1**

# EUROPEAN PATENT SPECIFICATION

(12)

(45) Date of publication of patent specification: **14.05.86**

(51) Int. Cl.⁴: **H 05 K 13/04**

(21) Application number: **83902440.3**

(22) Date of filing: **08.08.83**

(86) International application number:
**PCT/GB83/00197**

(87) International publication number:
**WO 84/00871 01.03.84 Gazette 84/06**

(54) IMPROVEMENTS IN AUTOMATIC ELECTRONIC ASSEMBLY.

(30) Priority: **10.08.82 GB 8222983**

(43) Date of publication of application:
**15.08.84 Bulletin 84/33**

(45) Publication of the grant of the patent:
**14.05.86 Bulletin 86/20**

(84) Designated Contracting States:
**BE DE FR NL SE**

(56) References cited:
**EP-A-0 079 402**
**FR-A-2 307 442**
**GB-A-2 066 199**
**US-A-3 389 771**
**US-A-3 533 498**
**US-A-4 307 988**
**US-A-4 314 628**
**US-A-4 327 483**

(73) Proprietor: **BURROUGHS CORPORATION (a
(a Michigan corporation)
Burroughs Place
Detroit, Michigan 48232 (US)**

(73) Proprietor: **BURROUGHS MACHINES LIMITED
Heathrow House, Bath Road Cranford
Hounslow Middlesex TW5 9QL (GB)**

(72) Inventor: **SWINNEN, Robert
Rue de la Briqueterie 26
B-Villers l'Eveque (BE)**
Inventor: **WATTEEUW, Ferdinand
Rue des Chataigniers 24
B-Oupeye (BE)**

(74) Representative: **Kirby, Harold Douglas Benson
et al
G.F. Redfern & Company Marlborough Lodge
14 Farncombe Road
Worthing West Sussex BN11 2BT (GB)**

Courier Press, Leamington Spa, England.

## Description

The present invention relates to the automatic assembly of printed-circuit boards. In particular, it relates to the automatic insertion of integrated-circuit packages into a printed-circuit board. In greatest particularity, it relates to apparatus for assembling a stick of selectably different integrated circuit packages in a predetermined order for later use by an insertion machine.

It is known to select integrated circuits in a predetermined order from an array of integrated circuit reservoirs or sticks. The integrated circuit packages lie in single file in the sticks, each of the sticks being a hollow tube generally conformal with the outline of the integrated circuit packages and allowing the integrated circuit packages to slide freely therein the packages being insertable into and removable from the sticks at either end. The sticks are held in a vertical position so that the packages are urged towards an open end by gravity, a plurality of sticks being so provided in parallel array. The leading package in each stick falls onto a mandrel intermediate with the legs of the package wherefrom further fall is prevented by a removable terminal stop. The next package in the stick°is prevented from falling onto the leading package by a removable clamp.

A package collecting module is positionable beneath any selectable one of the sticks in the array to collect a package therefrom. The positioning is accomplished using servo motors and the like to drive timing belts or leadscrews. The collecting module comprises a further mandrel closed at its lower end by a further removable stop. When the collecting module arrives beneath the selected stick, the terminal stop on the mandrel beneath the stick is removed. The leading package therefore falls onto the mandrel in the collecting module but is prevented from further fall therefrom by the terminal stop at the end of the mandrel in the module. The next package in the stick cannot fall since it is held in place by the removable clamp. In this way just one package is dispensed into and held in the module. After the dispensing the removable terminal stop at the end of the mandrel in the stick is replaced and the removable clamp removed. The previously-clamped package falls against the terminal stop to become the leading package and the clamp is replaced to clamp the next package thereafter in the stick. The module moves off from beneath the selected stick back to a work station where the package is allowed to fall from the module by the opening of the terminal stop on the bottom of its mandrel. One of several things can then be done to the integrated circuit. The integrated circuit can be tested and dispensed into a further stick if found working or discarded if non-functional. As an alternative, the package can be inserted directly into a printed circuit board positioned beneath the work station on an X-Y coordinate table as part of the assembly process of the board. Thereafter another package perhaps of a different kind from another stick or from the same stick can be selected for insertion into another position on the board which is brought beneath the work station by the table. Such a machine is exemplified by the Model 6785 DIP inserting machine made by the Universal Instruments Corporation of Binghampton, New York State.

In an alternative style of machine, typified by the CI 1000 DIP inserter made by the Amistar Corporation, the movable module is replaced by a common slanting runway whereon packages can be individually dispensed to slide by gravity towards the work station. The runway passes beneath all of the linearly-arrayed sticks.

Such arrangements are acceptable where only a small number of different kinds of integrated circuits are to be used. However, with the trend towards more and more different kinds of integrated circuit, and the requirement for adaptability of machines where one machine is expected merely by a change of program to deal with the requirements for a plurality of printed circuit boards, the number of different kinds of packages has steadily increased to the point where, even if each stick assembly is crowded up to occupy only 5 cm, a machine capable of operating among a range of 200 sticks would be more than 10 m long. In addition, the transit time of each package to the work station, and in the first instance of the prior art, of the collection module out to the stick would become excessively large making the machine very slow in operation.

In an effort to speed the assembly of boards special sticks of integrated circuit packages can be pre-assembled where an ordered set of different kinds of integrated circuits are assembled in the same stick. In the assembly process the special, mixed stick can be placed among the more common sticks and can contain the more uncommon integrated circuits, thus allowing a smaller machine to handle a wider number of different integrated circuit types. The ordered, different packages are taken from the mixed stick in the same way as any other but must be in the correct sequence to comply with the operating sequence of the board-assembling machine. There must be a separate type of mixed stick for each kind of printed circuit board to be assembled, sometimes more than one mixed stick per board type. All of the sticks in the assembly machine cam be made mixed sticks and certainly assembly time for the assembly machine is reduced. However, in order to obtain the mixed sticks, a separate stick preparing machine is required which, since it must work by the same principles, will either require a great deal of operator intervention if the machine is to remain small or will require to be of enormous size and great slowness if the machine is to accommodate the large number of different integrated circuit types. The problem therefore remains substantially unsolved, merely having been moved to a different location.

Accordingly it is desirable to provide an apparatus for accommodating a large number of different types of integrated circuit packages within a small volume where the packages are selectable for use in a selectable predetermined sequence of types. It is further desirable that each of the different types of package be accessible to the apparatus from sticks. It is yet further desirable to provide that said apparatus is operable to assemble one or more sticks of said different types of packages in said predetermined sequence.

According to a first aspect, the present invention consists in an apparatus for assembling a serial queue of different types of integrated circuit packages in an ordered set, said apparatus being characterised by including: a plurality of dispensing runways each for receiving a serial queue of a different one from among a plurality of different types of integrated circuit package at a receiving end and for making available said queue at a dispensing end, said runways being disposed to present said plurality of dispensing ends at a corresponding plurality of spaced locations in a two-dimensional array, and further comprising a positioner, a package-manipulating arm and an assembly point, said positioner being operable to move said positioner in a plurality of round trips between said assembly point and an equiplural predetermined sequence from among said spaced locations, said arm being operable to remove a package from the dispensing end of the runway at each of said spaced locations in said predetermined sequence and to deposit said removed package at said assembly point on each occasion of arrival thereat.

According to a second aspect said assembly point of said first aspect comprises a plurality of receiving runways for receiving said packages into a plurality of sticks.

According to a third aspect, said invention consists in an apparatus comprising a plurality of dispensing runways and a plurality of receiving runways according to the first and second aspects where said plurality of dispensing runways are disposed in a regular rectangular array sloping to urge said packages towards said dispensing ends by gravity and where said plurality of receiving runways are disposed in a regular rectangular array proximate to said array of dispensing runways sloping to urge said received packages towards said plurality of sticks by gravity.

According to a fourth aspect the invention consists in an apparatus according to the first to third aspects where each of said runways consists in the side walls of two adjacent U-shaped members whereover said packages and said sticks can sit astride and where said arm comprises a gripper operable to be inserted into the interstice between said walls to grip or release said packages.

According to a fifth aspect, the present invention consists in an apparatus according to the fourth aspect where said side walls defining each one of said receiving runways each comprise a rounded crown for the deposition thereon of a package by said gripper and where said package-manipulating arm comprises a gaseous-discharge nozzle for blowing said deposited package to tilt on said rounded crowns to slide down said runway.

In a preferred embodiment the apparatus is preferably housed within a rectangular cabinet. The cabinet preferably comprises an operator-access face and a rear, operating face. A plurality of dispensing runways is preferably arranged in a regular, rectangular array sloping between a high point on said operator access face to a low point on said operating face. Each of said dispensing runways is preferably capable of receiving a stick of integrated circuit packages from its receiving end on said operator-access face of-said cabinet. A plurality of receiving runways is preferably disposed in a preferably regular rectangular array to slope from a high point at said operating face to a low point at said operator-access face of said cabinet. Each of said receiving runways preferably accepts the insertion of an empty stick from the operator-access end thereof for the collection of packages dispensed into said receiving runway therein. Packages preferably slide by gravity from the operator-access end of each of said dispensing runways to said operating end thereof and preferably slide by gravity from the operating end of each of said receiving runways to said operator-access end thereof.

The plurality of dispensing runways preferably comprises runways of a plurality of sizes for the accommodation of a plurality of different varieties of package sizes, and the plurality of receiving runways preferably comprises receiving runways of a corresponding range of sizes.

Each of the runways is preferably formed by the adjacent walls of adjacent, parallel U-shaped channels. A package can preferably sit with its legs astride the two walls. A stick preferably can also sit astride the walls to dispense a package onto or receive a package from the runway dependently upon whether the runway is a receiving or a dispensing runway.

Each of the dispensing sticks preferably comprises a dispensing end at said operating face of said cabinet. Each of the dispensing ends preferably comprises a stop for preventing the gravity-urged egress of a package therefrom. The stop is preferably formed by the cutting of a dip in each of the walls of the U-shaped sections defining each dispensing runway into which the leading edge of a package is preferably able to fall, the dip having a shear edge proximate to the operating face to retain the package. A plurality of adjacent dispensing runways preferably share a retaining plate planarly-parallel and proximate to the package in said dip to engage said package to prevent the gravitational urge from other packages in the dispensing runway from pushing the package in the dip to tilt up and out of the runway.

The operating end of each receiving runway preferably comprises a rounded crown on each of the defining walls of the U-shaped sections. The crown is preferably such that a package can sit with its legs astride the walls on the crown. The rounded crown is preferably set in an expanding pair of wedge-shaped walls such that a package set on the crown encounters the narrow end of the wedge and is successively centred on the runway as it progresses towards the operator-access end thereof. The base of each adjacent U-shaped section preferably comprises a chamfer at the leading edge thereof to prevent fouling of the legs of a package thereon as it is placed on the crown.

The apparatus preferably comprises a package selecting mechanism on the operating face thereof. The package selecting mechanism preferably comprises a packing lifting module movable to any one of the exposed ends of the delivery runways or the receiving runways. The movement is preferably achieved using a stepping motor drive for the vertical positioning and a further stepping motor drive for the horizontal positioning. Each of the stepping motor drives is preferably provided with an encoder to provide indication of the position of the package lifting module. The apparatus preferably comprises a home position detector for detecting when the package lifting module is at a predetermined starting position to enable the correct accounting of the position of the module.

The package lifting module preferably comprises an arm and a gripper. The arm is preferably operable to advance the gripper towards the operating face of the apparatus and the gripper is preferably operable when in the advanced position to grip or release a package.

The gripper preferably comprises upper and lower jaws. The lower jaw is preferably insertable into the interstice between the walls of the U-shaped channels to grip a package between its rows of legs.

The upper and lower jaws preferably present parallel faces to the package angled such that when a package is removed from a dispensing runway its body clears the stops.

The gripper preferably comprises a gaseous discharge nozzle. The nozzle preferably dispenses a jet of compressed air at a selectable instant. The nozzle preferably overlooks the top jaw. The nozzle is preferably operable during the placing of a package into a receiving runway.

In placing a package into a receiving runway, the gripper preferably releases the package to rest atop the rounded crown, wherefrom the package may or may not slide towards the operator-access face of the apparatus. The jet of compressed air is preferably provided just after the release of the package by the gripper. In the event of the package not having fallen towards the operator-access face of the apparatus, the jet preferably tilts the package properly onto the runway and urges it towards the operator-access face.

The apparatus is preferably sequence controlled. The gripper preferably comprises a detector for detecting when a package is actually gripped. The spacing of the upper and lower jaws is preferably closer when closed in the absence of a package therebetween than when a package is present. If at any time after the closure of the jaws when a package should be therebetween it is detected that the jaws are at the closer-together position, the sequence preferably repeats the last required step and if failure is repeated, stops and indicates the nature of the failure.

The apparatus preferably sends the package-lifting module on a series of round trips. Each round trip preferably sends the module to a selectable one of the dispensing runways where the arm advances the gripper which grips a package. Each round trip preferably terminates by the module being sent to a selectable one of the receiving runways where the arm once more advances the gripper to release the package as described to fall into a receiving stick. The arm preferably retracts the gripper during movement across the operating face of the apparatus so as not to foul any part of the apparatus.

The apparatus preferably comprises one or more integrated circuit testing stations. The apparatus is preferably operable to include a testing station within a round trip, in which case the apparatus is preferably operable to move the module to the testing station, to operate the arm and the gripper to dispense the package into the testing station, to initiate testing, and to operate the arm and the gripper to remove the package from the testing station after the test. The apparatus preferably comprises a discard stick as one of the receiving runway terminations. The discard stick is preferably to receive those packages which fail their functional test. In the event of failure of the test the round trip preferably terminates at the discard runway.

The operation of the arm and of the gripper is preferably powered and controlled pneumatically, in which case the apparatus preferably comprises a pneumatic control box operable in response to the receipt of logic signals from a sequence controller to dispense compressed air from an incoming pressure supply line via selectably operable valves to power the arm and gripper.

The sequence controller preferably is operable to execute any selectable one of a plurality of different sequences each intended to assemble a different random stick or sticks. The sequence controller preferably is coupled to receive the outputs of the encoders and of the home position detector and is operable to respond thereto to control the vertical and horizontal stepping motor positioners in the execution of the sequence.

The apparatus preferably comprises a plural numerical display. The sequence controller, whenever the package lifting module is sent to a particular one of the dispensing runways, is preferably operable to recall and display on the display a plural digit number (the part number) indicative of the type of package in that runway. The number preferably remains so displayed until the module is moved away. In this manner, when the operating sequence is suspended as a result of the gripper not having succeeded in picking up a package from the dispensing runway where it is located, the part number preferably remains displayed indicatively of which type of package requires to be replenished and/or of the type of package which was being accessed when difficulty was encountered.

The apparatus preferably comprises a plurality of indicator lights, one in proximate association with each of the dispensing runways on the operator-access face of the apparatus. The sequence controller is preferably operable to cause the illumination of the appropriate one of the plurality of lights whenever the package-lifting module accesses a particular dispensing runway. The light preferably remains illuminated for as long as the module remains threat. The apparatus thereby preferably not only displays the type of package which is in deficient supply via the numerical display but also which one of the dispensing runways requires attention whenever the apparatus should stop due to the failure of the gripper to acquire a package.

The apparatus preferably comprises a printer. The printer is preferably coupled to receive instructions from the sequence controller. At the start of a sequence the printer is preferably operable to print an appropriate number of adhesive labels for the number of sticks it is to assemble in the dispensing runways. Each of the labels preferably bears indication of the type of stick to be assembled.

The apparatus preferably comprises an alarm light on the operator access face thereof illuminatable in response to a command from the sequence controller indicatively of the sequence having been suspended in response to the gripper having failed to pick up a package. The apparatus also preferably comprises a restart button which is manually operable by the operator in response to observation of the alarm light to force the retry and continuation of the sequence prior to operator intervention.

The invention is further explained, in greater detail and by way of an example, by the following description in conjunction with the appended drawings, wherein:

Figure 1 shows the overall system of the present invention.

Figure 2 shows the package sorter of figure 1 in cross-sectional view.

Figure 3 shows the view of the package sorter of figures 1 and 2 from the operating face.

Figure 4 shows an isometric view of the end of the dispensing runways on the operating face of the package sorter.

Figure 5 shows an isometric view of the ends of the receiving runways on the operating face of the package sorter.

Figure 6 shows a plan view of the ends of the receiving runways of figure 5.

Figure 7 shows the arm and gripper in the act of holding a package.

Figure 8 shows the arm and gripper in the act of attempting to grip a package but in the absence of a package.

Figure 9A shows an elevation view of the lower jaw of the gripper and figure 9B shows a plan view thereof.

Figure 10 shows the gripper removing a package from a dispensing runway.

Figure 11 shows the gripper placing a package onto a receiving runway.

Figure 12 is a flowchart depicting the operation of the overall system.

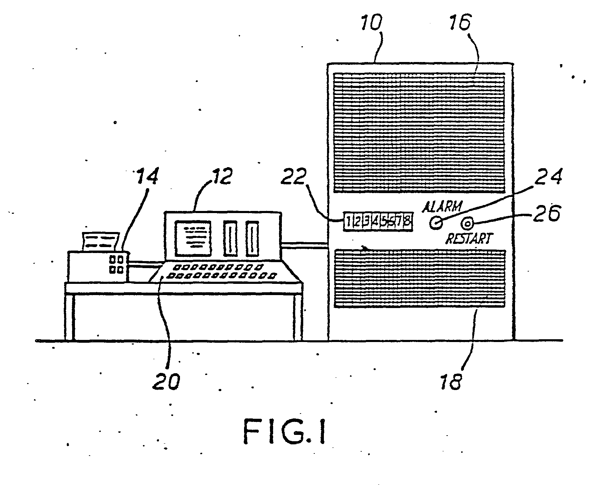

Figure 1 shows the overall configuration of the system of the present invention. A package sorter 10 is controlled by a sequence controller 12 which is also operable to drive a label printer 14. The sorter 10 comprises a plurality of dispensing runways 16 arranged in a regular rectangular matrix. Each of the runways 16 can take a single type of Dual-in-Line integrated circuit package, a plurality of package types thereby being accommodated in a plurality of dispensing runways 16. The sorter 10 also comprises a plurality of receiving runways 18 also arranged in a regular rectangular matrix. The object of the system is to select packages from the dispensing runways 16 in an ordered sequence and to deposit them into the receiving runways where they are held in integrated circuit sticks, well known in the art, for removal and subsequent use elsewhere by an automatic integrated circuit package inserting machine.

The printer is used solely for printing labels for the identification of assembled sticks. The printer 14 is used to print one more label than the number of sticks to be assembled by the sorter 10 so that not only each stick can be subsequently identified but also the rack where the sticks are to be held for later use.

The sequence controller 14 is shown for preference as a microcomputer or a microprocessor. Its exact form is not of particular importance, only its function. As will become apparent through the following description, its function could equally well be taken over by any state sequence machine. The sequence controller 14 could equally well be coupled to the system by remote data communications link. The sequence controller 14 could even be replaced by a machine which purely reads pre-punched tape or a stack of instruction cards, in which case whenever reference is made to the entering of data into the system it would be construed as the changing of one or more cards or of the instruction tape being employed. However, as stated, the sequence controller 14 is, for preference, a microcomputer, since, as will be apparent to those skilled in the art, this allows for the rapid loading of different instructions sequences from disc or tape store and also allows for easy operator intervention via the keyboard 20.

The sorter 10 comprises a display 22, a plural decimal digit display driven by the sequence controller 14. The sequence controller 14 activates the display 22 to indicate the identifying part number of the particular package which, at any instant, is being selected from a dispensing runway 16 for later deposition in a receiving runway 18. The sorter 10 also comprises an alarm light 24 for indicating when it has failed to acquire a package from a dispensing runway 16 on which event the sequence controller 14 freezes the sequence. The sorter 10 comprises a restart button 26 operable to cause the sequence controller 14 to recontinue its frozen sequence.

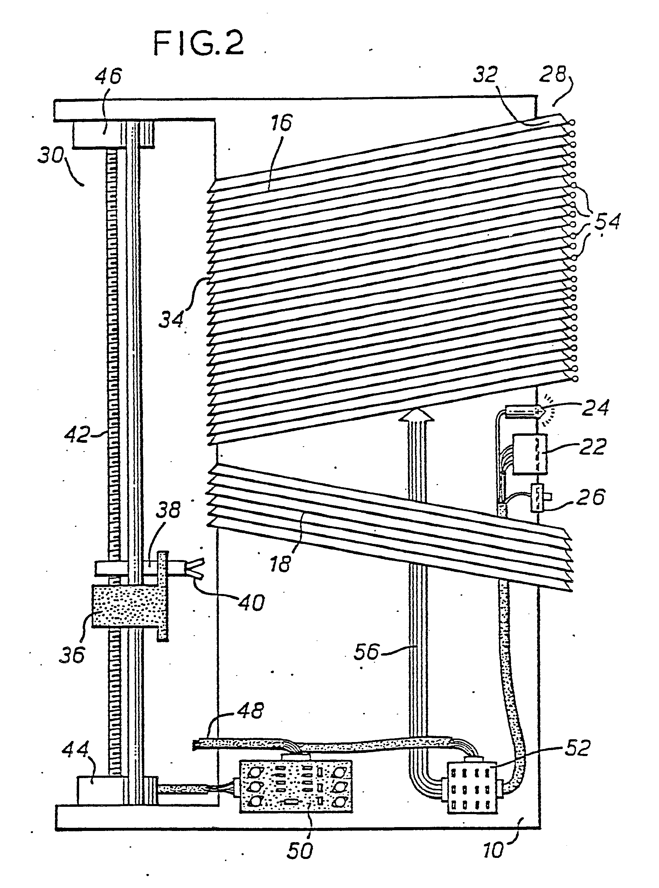

Figure 2 shows a cross-sectional view of the sorter 10. The sorter 10 generally comprises an operator access face 28 wherefrom the operator can gain access to the runways 16, 18 and the controls 22, 24, 26 and an operating face 30 remote from the operator whereon the selection and sorting of packages takes place.

Each of the dispensing runways 16 slopes downwards from the operator-access face 28 to the operating face 30. Each of the dispensing runways 16 comprises a receiving end 32 at the operator-access face 28 thereof and a dispensing end 34 at the operating face 30. Each of the receiving runways 18 slopes downwards from the operating face 30 of the sorter 10 to the operator-access face 28. The runways 16, 18 can each accommodate a single-file queue of dual-in-line integrated circuit packages. Because of the slopes, dispensing runways 16 have their queues of packages urged by gravity towards the operating face 30 of the sorter 10 and receiving runways 18 have their queues of packages urged by gravity towards the operator access face 28 of the sorter 10.

The sorter 10 comprises a package lifting module 36 whereon an arm 38 and a package gripper 40 are mounted. The package lifting module 36 is operable to be moved and positioned vertically by means of a leadscrew 42 threaded therein which is turned by a vertical stepping motor 44 and has its angular position sensed by a vertical shaft encoder 46. The arm 38 is operable to advance the gripper 40 towards the operating face 30 of the sorter 10 either to pick up a package from a dispensing runway 16 or to place a package in a receiving runway 18.

The sorter 10 is in part coupled to the sequence controller 14 via a first cable 48, used to communicate firstly with a stepping motor driver 50 and secondly with an operator interface 52.

The stepping motor driver 50 supplies controlled drive to the vertical stepping motor 44 and, as will later be described, to a horizontal stepping motor. The stepping motor driver 50 also is coupled to receive the output from the vertical encoder 46 and, as will later be described, from a horizontal encoder. The stepping motor driver 50 is operable to respond to commands from the sequence controller 14 in a manner to be described later to position the package lifting module 36 at selectable ones of the dispensing runways and receiving runways 18.

The operator interface 52 firstly communicates the condition of the restart switch 26 to the sequence controller 14. Secondly, the operator interface 52 keeps the numerical display 22 operating. It receives commands from the sequence controller 14 indicative of the numbers to be displayed in each position, latches those numbers, decodes the numbers into seven-segment display code, and drives the display 22. The manner of so doing can be any known in the art. Indeed, in appropriate circumstances the sequence controller 14 itself can be used to drive the display 22 by means of cyclic program loops and the like, all of which are also well known in the art.

Each of the receiving ends 32 of the dispensing runways 16 is provided with an individual light 54 in the form of an LED. The LED 54 being lit is intended to indicate from which one of the dispensing runways 16 the gripper 40 is currently in the process of removing a package. The sequence controller 14 communicates to the operator interface 52 which one of the LEDs 54 should be illuminated. The interface 52 decodes the command and lights the appropriate LED via a LED harness 56 which can be a wire pair for each LED 54, can operate the LEDs 54 on the basis of a crossing X-Y grid of cables only one out of each group of which is energised at any one time to illuminate that LED 54 at the crossing point of the energised wires, or indeed by any other method known in the art.

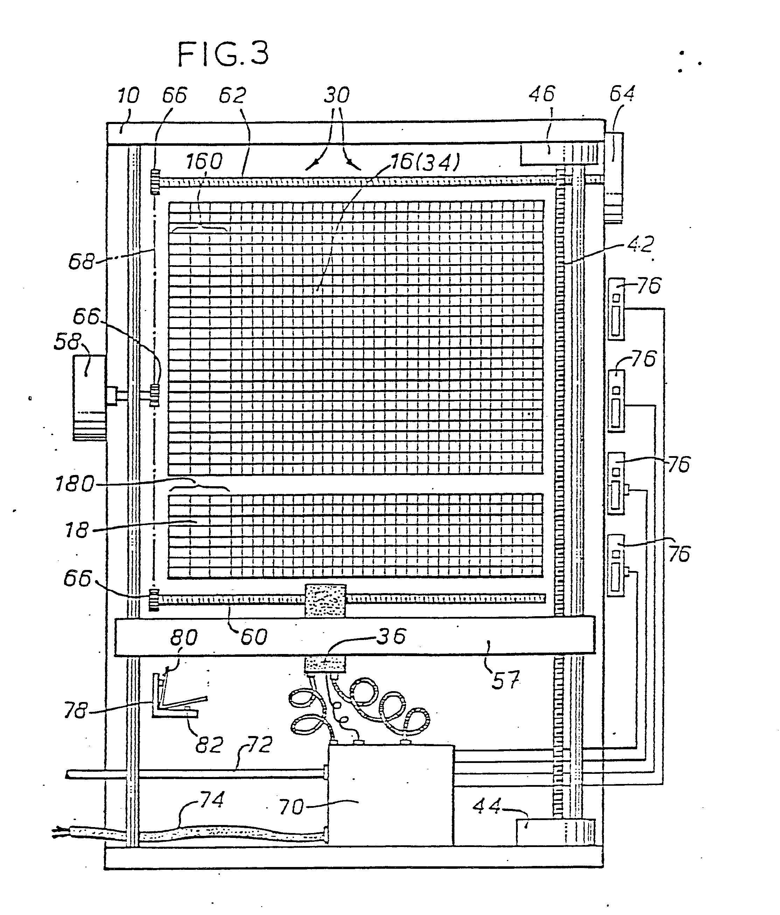

Figure 3 shows a view of the sorter 10 from the operating face 30. The dispensing ends 34 of the dispensing runways 16 form a regular rectangular matrix. Some of the dispensing runways 160 are of a wider size than the others to accommodate packages of greater dimensions. For example, if most of the packages were of the 14 or 16 pin Dual-in-line variety, some runways 160 are provided for the wider 24 pin and 40 pin dual-in-line variety of packages. There is no restriction on there being only two widths of runway 160, 16. There can be as many widths of runway 16 as is required for the operation of the machine. In a similar manner, some receiving runways 180 are made wider to accommodate the wider packages they might receive.

The package lifting module 36 is mounted on a horizontal bar 57 whereon it is free to be positioned in a horizontal axis by a horizontal stepping motor 58 driving a horizontal master leadscrew 60 for moving the package-lifting module 36 along the bar 57, and driving a slave horizontal leadscrew 62 for turning a horizontal encoder 64 for providing indication of the horizontal position of the module 36, both via a pulley system driven by a taut wire 68.

The sorter 10 comprises a pneumatic controller 70 in receipt of pressurised air via an air supply main 72 and in receipt of operating instructions from the sequence controller 14 via a second cable 74. The instructions are provided in the form of simple logic signals indicative of which ones out of a plurality of pneumatic control valves is to be opened to activate the sorter. The pneumatic controller 70 responds to the instructions by supplying air either to the package lifting module 36 for its operation in a manner later described and/or to any one out of a plurality of package testing stations 76 used in association with the sorter 10.

The sorter 10 comprises a home position detector 78 where a horizontal position sensing microswitch 80 detects when the package lifting module 36 reaches a predetermined horizontal position and a vertical position sensing microswitch 82 detects when the module reaches a predetermined vertical position. The outputs of the two microswitches 80, 82 are provided as input to the stepping motor driver 50.

The encoders 46, 64 give out one pulse for every unit increment of module 36 position in a vertical and horizontal position respectively. When the vertical microswitchh 82 operates it indicates that the next downwards output pulse from the vertical encoder 46 takes place with the module 36 in the vertical home position. When the horizontal microswitch 80 operates it indicates that the next output pulse from the horizontal encoder 64 with the module 36 moving to the left as seen in figure 3 takes place with the module 36 in the horizontal home position.

The stepping motor driver 50 comprises identical vertical and horizontal driving circuits. Each of the circuits comprises a latch for receiving a binary number from the sequence controller 14 indicative of the number of the X or Y position the gripper 40 should occupy. The number is representative in each case of the count of pulses from the respective encoders 46, 64 which should be achieved when the gripper 40 has arrived. Each circuit also comprises a counter and a numerical comparator. The counter counts the current number of encoder pulses the gripper 40 is away from the home position and the numerical comparator compares the count of the counter with the latched number from the sequence controller 14, providing output indicative of the count being less than, greater than or equal to the number from the sequence controller. A stepping motor sequence controller of any kind well known in the art is driven in sympathy with a stepping clock and the output of the numerical comparator to step the module 36 away from the home position if the number from the sequence controller 14 is greater than count on the counter, to step the module towards the home position if the number from the sequence controller 14 is less than the count of the counter, and to hold the module still if the number from the sequence controller 14 equals the count in the counter. As the module 36 moves the pulses from the encoders 46, 64 count their respective counters in the stepping motor driver 50 up or down as is appropriate to the sense of the numerical difference until required runway 16, 18. The stepping motor driver 50 is operable to receive a command from the sequence controller 14 for the initialising of its counters. In the initialising process, the module is stepped steadily back towards the home position in both axes until the microswitches 80, 82 operate. When each of the microswitches operates it prepares the counter to be reset to zero on receipt of the next appropriate encoder pulse and the stepping process halted in that axis.

The binary address numbers are communicated to the stepping motor driver 50 as two, parallel plural binary digit numbers together with a latch pulse for operating the latches in the driver 50. As soon as the latch pulse is received the driver 50 the module 36 heads towards its required destination. As the count becomes equal to the supplied number in each case it sets an "arrived" line high. When both such lines bear a logically high signal they are combined in an AND gate whose output is coupled back to the sequence controller 14 to indicate that movement is complete so that the sequence controller 14 can pass on to the next operation.

The positioning of the module need not necessarily be achieved in the manner described. The encoders 64, 46 can be omitted and positioning achieved by counting the number of steps administered to the motors 44, 58. The stepping motors can be replaced by linear motors with the encoders in a pair of linear feedback servomechanisms. Those skilled in the art will be aware of many variants in the manner of positioning the module 36 each equally applicable to the operation of the present invention as defined in the claims. The manner described is merely by way of illustration to clarify the operation of the sorter 10 and its manner of receiving instructions from the sequence controller 14.

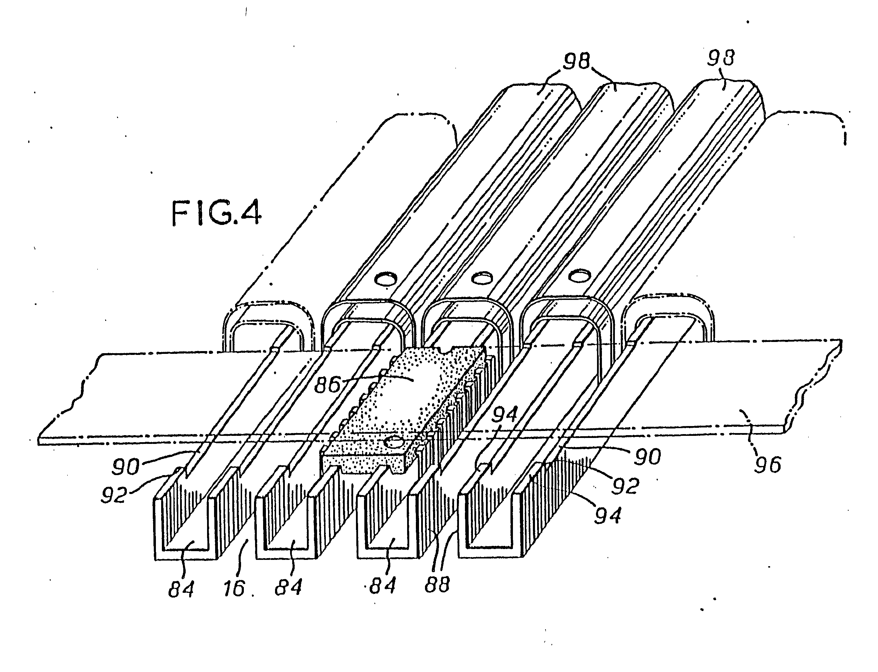

Figure 4 illustrates the dispensing ends 34 of some of the dispensing runways 16. The runways 16 are formed by the parallel adjacence of U-shaped channels 84, adjacent walls 88 of the channels 84 being so spaced that a Dual-in-Line package 86 can sit with its legs astride the walls 88.

Each of the walls 88 has a cutaway section 90 in its top proximate to its end. The cutaway sections 90 comprise a bluff edge 92 for retaining the package 86 against the retaining lug 94 so formed. A common plate 96, shown in phantom, extends across a plurality of the runways 16 retains any chips 86 which might be urged by the gravitational push of following chips 86 on the runway to tip upwards at its end remote from the lugs 94 and be turned over to be expelled from the runway 16 in an unintended manner.

Each of the runways 16 is designed to receive a package bearing stick 98 of a design very well known in the art. The sticks 98 are each capable of sitting astride the pairs of walls 88 defining a runway to dispense the packages 86 they contain onto their respective runways 16. The sticks 98 each contain a single variety of packaged integrated circuit, this being the manner of delivery of the integrated circuits. An empty stick 98 can be replaced in toto by the operator from the operator-access face 28 of the sorter 10 or can merely be refilled by the operator tipping the contents of a filled stick into the empty stick 98 still in situ. In the sticks 98 the packages 86 sit in single file and are fed by gravity towards the lugs 94.

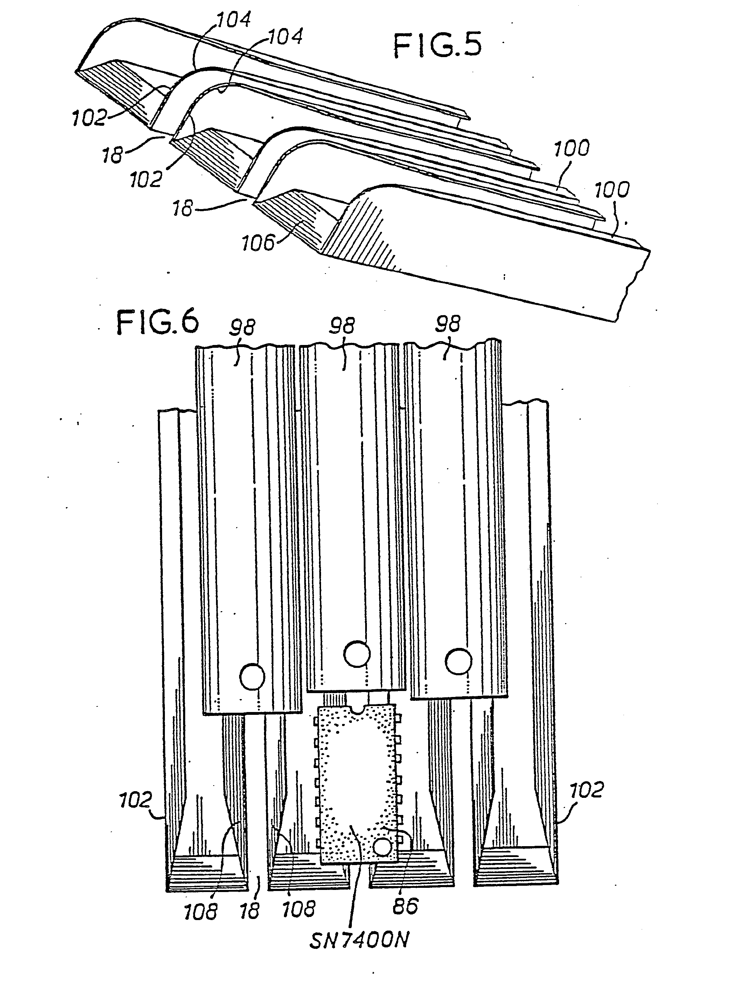

Figure 5 shows an isometric view of the operating face 30 ends of some of the receiving runways 18.

The receiving runways 18 are formed by the adjacent parallel combination of second U-shaped channels 100. An adjacent pair of side walls 102 forms each runway 18 and a package can sit with its legs astride the two walls 102 just as in the case of the dispensing runways 16. Similarly a stick for receiving the packages can also sit astride the walls 102. The walls 102 each have a rounded leading edge 104. These allow a package to be placed thereon prior to sliding down into the stick. Each of the U-shaped channels 106 has a chamfered leading edge to its base 106 so that the legs of a package do not foul the base as the package is placed upon the rounded edges 104. The combination of rounded edges 104 and the chamfers 106 allows for a range manners of presentation of packages of differing dimensions to be accommodated.

Figure 6 shows a plan view of the receiving runways 18 of figure 5. In addition to the features already described, each wall 102 comprises a leading wedge 108. When a package 86 is to be placed on a receiving runway 18 the leading wedges 108 on the pair of adjacent walls 102 forming the runway 18 combine to minimise the apparent width of the pair of walls 102. This enables the package 86 to be placed astride the walls 102 despite an allowable error in its positioning relative to the centre line of the runway 18.

Sticks 98 sit astride the walls 102 just as the sticks 98 sit astride the walls 88 of the dispensing runways 16 with the difference that, whereas packages 86 in the case of the dispensing runways 16 are urged out of the sticks 98 by gravity, in the case of the receiving runways 18 the packages 86 are urged into the sticks 98 by gravity. In the case of the receiving runways 18 the sticks 98 are intended to receive an ordered succession of different types of packaged integrated circuits. At the end of a stick assembly sequence the sticks 98 on the receiving runways 18 are each full with their respective ordered successions of packages. The operator then removes the sticks 98 from the operator-access face 28 of the sorter 10 for subsequent use by a conventional package insertion machine in the assembly of a printed circuit board. The operator places one label on each of the removed sticks and the remaining label in their storage rack.

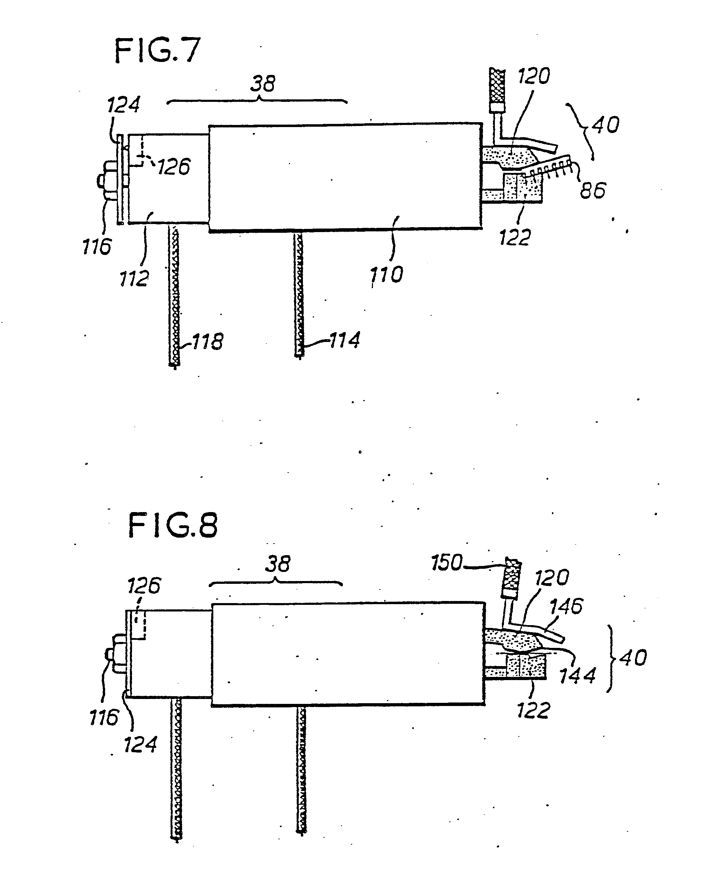

Figure 7 shows the gripper 40 and arm 40 assembly on the package-lifting module 36, gripping a package 86.

The arm 38 comprises an outer sleeve 110 slidable over an inner sleeve 112. The outer sleeve 110 is fixed in the module 36 and the inner sleeve 112 can be actuated via a first air line 114 to move the gripper 40 which is affixed within the inner sleeve 112 away from the operating face 30 of the sorter 10 when there is no pressure in the first air line 114 under spring return force and to advance the gripper 40 to engage the operating face 30 of the sorter 10 when there is sufficient pressure in the first air line 114 to drive a piston to overcome the spring return force. The operation of the first air line 114 is controlled by the sequence controller 14 via the pneumatic controller 70, so that the sequence controller 14 can cause the supply of air to be given or cut off to selectably advance or retract the inner sleeve 112. Those skilled in the art will be aware of many ways in which the pneumatic advance and retraction of the gripper can be achieved. The exact manner of the operation is not important in the present invention save that it be selectably operable by the sequence controller 14. It will become apparent to those skilled in the art that other methods of advancing the gripper 40 are equally suitable for the present invention, such as the use of electric or hydraulic motors.

A pneumatically-driven ram 116 is operable in response to air pressure being present in a second air line 118 under selectable control of the sequence controller 14 via the pneumatic controller 70 to advance towards the operating face 30 of the sorter 10 in the presence of pressurised air to insert a wedge to push an upper jaw 120 of the gripper 40 against a lower jaw 122 of the gripper 40 to grip a package 86 therebetween and operable in the absence of pressurised air to retract the wedge under spring return force to allow the upper 120 and lower 122 jaws to move apart and release the package 82. Those skilled in the art will be aware of other ways in which the jaws 120, 122 can be operated by the use of solenoids, differential pneumatic motors, hydraulic motors, electric motors and the like. It is not important to the present invention exactly how the jaws 120, 122 open and close, merely that they can be made to open and close in response to commands from the sequence controller 14, which in this case is achieved by the sequence controller 14 sending a logic signal to the pneumatic controller 70 causing it to open a valve between the air supply main 72 and the second air line 118 to supply pressurised air thereto.

The ram 116 is provided with a coaxial terminal disc 124 which meets the end face of the inner sleeve 112 whenever the jaws 120, 122 are completely closed, in which position it operates a package absence detecting microswitch 126 set in the end face of the inner sleeve 112. However, when a package 86 is in fact gripped between the upper 120 and lower 122 jaws, the thickness of the package 86 prevents the jaws 120, 122 from closing all the way. The ram 116 is thereby prevented from moving towards the operating face 30 of the sorter 10 to its full extent and the disc 124 is prevented from engaging the end face of the inner sleeve 112 to operate the microswitch 126.

Figure 8 shows the situation where the arm 38 and gripper 40 of figure 7 have been caused to close the jaws 120, 122 without a package 86 therebetween. With nothing to keep the jaws 120, 122 apart the ram 116 is free to travel its full extent and push the disc 126 against the end face of the inner sleeve 112 to operate the microswitch 126. The operation of the microswitch 126 is therefore indicative of the jaws 120, 122 having been closed without a package therebetween. The state of the microswitch 126 is communicated to the sequence controller 14 via the interface 52.

Whenever the sequence controller 14 observes the operation of the package absence detecting microswitch 126 it concludes that the particular one of the dispensing runways 16 at which it has just attempted to grasp a package 86 has in fact run out of packages 86. Whatever the cause of the operation of the microswitch 126, the·sequence controller 14 freezes its operation, waiting for a manual restart from the operator via the restart button 26, lighting the alarm light 24, continuing to show the part number of the missing type of package 86 on the numerical display 22 and keeping illuminated the LED 54 on the receiving end 32 of the appropriate dispensing runway from which it has just failed to grip a package. In this way the operator knows that something is wrong and what type of package to resupply and where to resupply it.

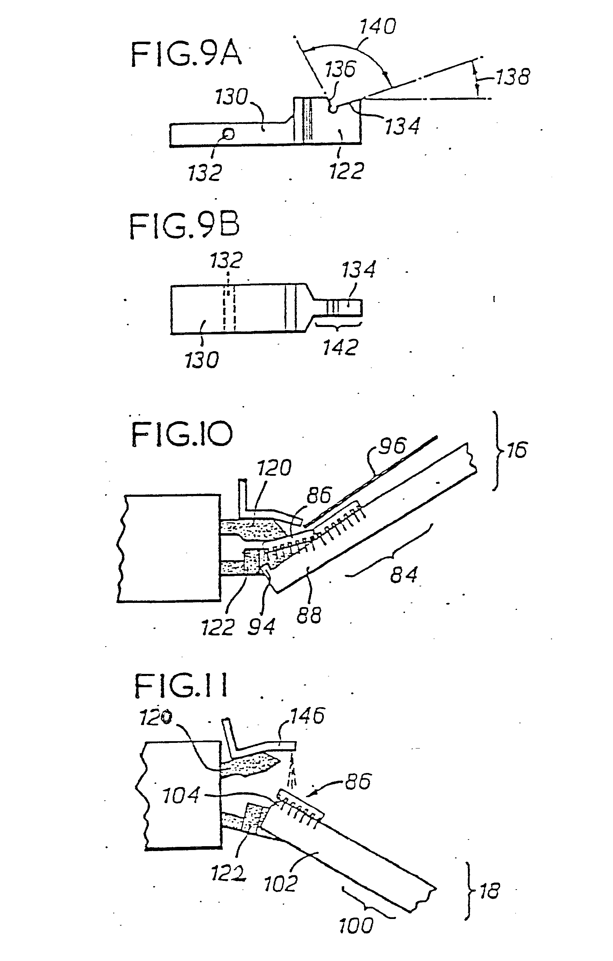

Figure 9A shows an elevation view of the lower jaw 122 of the gripper 40 and figure 9B shows a plan view thereof. The lower jaw 122 is supported by an actuating lever 130 rotatable about a pivot 132 in opposition with a corresponding lever on the upper jaw 120 and it will be apparent therefore how the ram 116 can insert a wedge between the levers to cause the jaws 120, 122 to close.

The lower jaw 122 comprises a bearing face 134 and a rear face 136. The bearing face 134 is not parallel to the direction of movement of the ram 116, but deviates therefrom such that the angle 138 is elevated in the region of 17 degrees. In this way when a package 86 is gripped between the jaws 120, 122 it sits at 17 degrees to the horizontal plane. This allows the package 86 to clear the lugs 94 at the dispensing ends 34 of the dispensing runways 16 in a manner to be described at a later point.

The rear face 136 is set at the rear of and angled to the bearing face 134 such that the angle 140 approximates to ninety degrees, thus allowing the accomodation of the body of a package resting on the two faces 134, 136.

The lower jaw 122 comprises a forward narrow section 142 seen in the plan view of figure 9B. The narrow section 142 includes the bearing face 134 and the rear face 136. The narrow section 142 allows the insertion of the lower jaw 122 between the U-Shaped channels 84 defining the dispensing runways 16 and between the U-Shaped channels 100 defining the receiving runways 18. In this way the lower jaw 122 is enabled to reach up and grip the body of a package 86 between its rows of legs.

Returning to figure 8, it is seen that the upper jaw 120 has a package-grasping face 144 which is angled relatively to the motion of the ram 116 such that when a package is gripped between the upper and lower jaws 120, 122 the package-grasping face 144 is parallel with the bearing face 134 of the lower jaw 122.

Figure 8 also shows an air nozzle 146 affixed to the upper jaw 120 and provided with air by a third air line 150 selectably operable, by the sequence controller 14 instructing the pneumatic controller 70 to allow air from the pressurised main 72 via a selectably operable valve into the third air line 150, to direct a jet of air having a component of motion in the direction of motion of the ram 116 and a further component of motion in a downward direction, towards the operating face 30 of the sorter 10.

Figure 10 shows the gripper 40 picking up a package 86 from a dispensing runway 16. The gripper 40 is advanced by the arm 38 with the jaws 120, 122 in the open position (the ram 116 fully out) towards the dispensing runway 16. Once in position, the sequence controller 14 commands the pneumatic controller 70 to provide air to the second air line 118 to close the jaws 120, 122. The upper jaw 120 does not have a narrow section 142 unlike the lower jaw 122. The Upper jaw 120 therefore descends upon the package 86 to provide a large supportive base. Meanwhile the lower jaw 122 passes up between the walls 88 defining the dispensing runway 16 to grasp the package 86 body between the rows of legs. In being grasped, the package 86 is tilted via the mutual clamping action of the bearing face 134 and the package-grasping face 144 to take up the angle 138 to the horizontal defined by the bearing face 134. In so doing, the package 86 is tilted to clear the lugs 94 at the distal ends of the walls 88 of the U-shaped channels 84. The package is also tilted insufficiently to foul the plate 96. In this manner the sequence controller 14 is next able to instruct the arm 38 to withdraw the gripper 40 away from the dispensing runway 16 and the package 86 will come cleanly out.

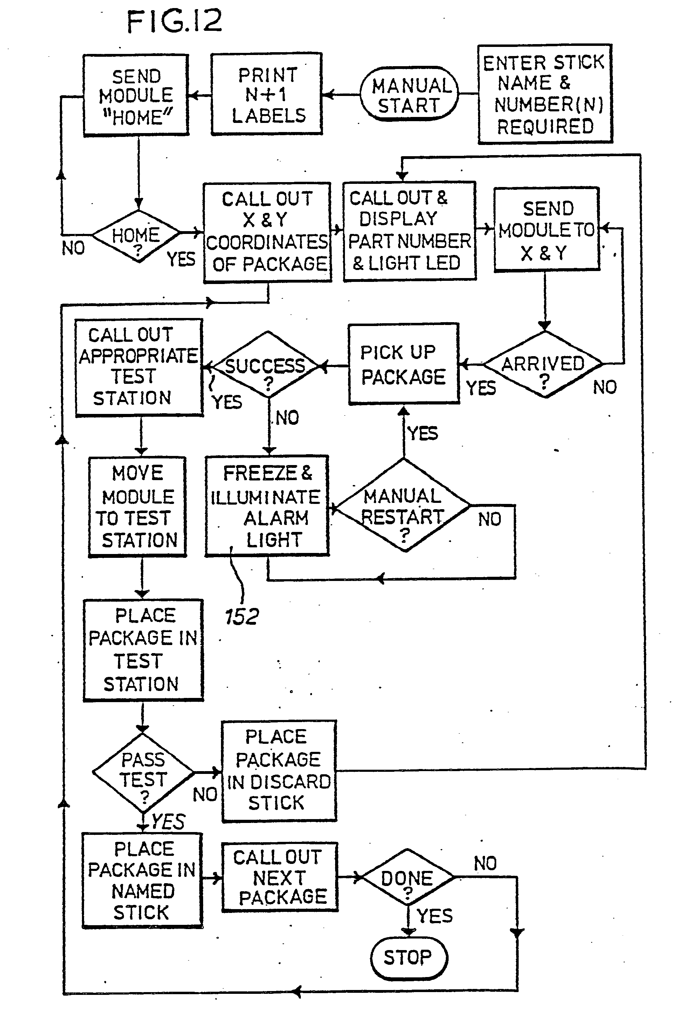

Figure 11 shows the gripper 40 placing a package 86 into a receiving runway 18. The arm 38 at the end of a movement of the module 36 to the operating face 30 end of the receiving runway 18 with the gripper 40 retracted, advances the gripper 40 to the receiving ramp 18 and opens the upper and lower jaws 120, 122. The package 86 is thereby deposited on the rounded edges 104 of the walls 102 of the U-Shaped channels 100. All things being equal, despite the angled manner in which the package 86 is placed on the rounded edges 104 as a result of the mutual clamping action of the bearing face 134 and the package-gripping face 144 in the lower 122 and upper jaws 120 respectively maintaining the package 86 up to the moment of release at an angle to the horizontal, the package 86 should automatically tilt and slide down the receiving runway 18. However, some packages can stick in place due to higher frictional coefficients between their bodies and the material of the walls, and other reasons. To prevent the malfunction of the sorter 10 which such sticking would cause, the sequence controller 14, immediately after causing the jaws 120, 122 to open, causes the nozzle 146 to emit its air jet to ensure the tilting of the package 86 and to ensure that it is driven down the runway to fall into the stick 98.

It is to be appreciated that the angle 138 of the bearing face 134 is not restricted to the region of 17 degrees. By varying the dimensions of the lugs 94, the angle of drop of the dispensing runways 16 and the size of the plate 96 it will be clear that other angles 138 can be used within the restrictions described above.

In its operation, the system selects packages 86 from among the selection of types available from the dispensing runways 16 to assemble a selectable number of random sticks in the receiving runways 18. The module 36 makes a series of round trips under the control of the sequence controller 14. Each round trip starts off with the module being sent to a selected dispensing runway 16. At the selected dispensing runway 16 the arm 38 advances the gripper 40 to take a package from the selected dispensing runway 16 can be of the same type in the manner in which it is common for manufacturers of integrated circuits to supply them, but there is really no restriction in that direction and the contents of the dispensing runway 16 selected could equally well be the result of the assembly of an earlier random stick, provided the operating sequence of the sequence controller 14 takes account of the ordering of the types of package within the random stick. The package 86 having been grasped by the gripper 40, the arm 38 retracts the gripper 40 from the dispensing runway 16. The module 36 is then moved to its next destination. In some circumstances it may be desired to test the package. While the description is hereinafter written as if all packages are tested it is to be understood that the testing stage can be omitted if desired. The module 36 is moved to a selected one of a plurality of test stations 76 as shown in figure 3 where the arm 38 advances the gripper 40 to deposit the package 86 into the station 76. It is not important to the invention what the exact nature of the testing station 76 might be. The sequence controller 14 commands the tester 76 to perform the test appropriate to the type of package presented to the selected test controller 14 whether or not the package passed the test.

At the end of the test the sequence controller 14 readvances the arm 38 and allows the gripper 40 to pick up the package 86 from the test station. The arm 38 is then retracted and the module 36 sent to its terminal destination in the round trip. If the package 86 passed the test the terminal destination is that stick in the receiving runways 18 where the random sequence of packages 86 is to be assembled. If the package does not pass the test the terminal destination is a special discard stick in the receiving runways where all non-functional packages are kept for later analysis or abandonment. In this latter event the module 36 returns one more on a second round trip to try and replace the package which was found to be non-functional.

Figure 12 is a flow chart indicative of the overall operation of the system and explains in graphic form the foregoing written description. It will be apparent to those skilled in the art that an instruction to attempt a predetermined number of re-attempts to pick up a package before freezing can be included in instruction designated 152.

## Claims

1. An apparatus for assembling a serial queue of different types of integrated circuit packages in an ordered set, said apparatus being characterised by including: a plurality of dispensing runways each for receiving a serial queue of integrated circuit packages at a receiving end thereof and for making said packages available at a dispensing end thereof said plurality of dispensing runways being disposed to present the corresponding plurality of dispensing ends at a corresponding plurality of spaced locations in a two-dimensional array, said apparatus further comprising a positioner, a package manipulating module and an assembly point, said positioner being operable to move said module in a plurality of round trips between said assembly point and an equiplural predetermined sequence from among said spaced locations, and said module being operable to remove a package from the dispensing end of the dispensing runway in each of said spaced locations in said predetermined sequence and to deposit said removed package at said assembly point on each occasion of arrival thereat.

2. An apparatus according to claim 1 wherein said assembly point comprises a plurality of receiving runways and wherein said positioner is operable to position said module among said receiving runways as part of said predetermined sequence to select ones from among said plurality of receiving runways for said module to deposit said removed package therein.

3. An apparatus according to claim 2 wherein each of said dispensing runways is disposed at an angle to the horizontal for gravity to urge said queue of packages towards said dispensing end, and where each of said plurality of receiving runways is disposed at an angle to the horizontal for said received package to be urged by gravity away from the point of deposition by said module.

4. An apparatus according to claims 1 to 3 wherein each of said dispensing runways consists in the parallel proximate association of two U-Shaped channels astride the adjacent walls of which a package can sit with its two sets of legs in either channel.

5. An apparatus according to claim 4 wherein said plurality of spaced locations form a regular rectangular array and where each plane of dispensing runways comprises a plurality of said U-Shaped channels in common parallel association.

6. An apparatus according to claim 5 wherein each of the walls of said U-Shaped channels comprises a lug for preventing the egress of the terminal one in said queue of packages at the dispensing end thereof and a plate for preventing the tilting egress of said terminal package under the gravitational urging of later packages in said queue.

7. An apparatus according to any one of the preceding claims wherein said positioner comprises a vertical positioning servomechanism operable to position said module at any selectable one of a plurality of vertical coordinates and a horizontal positioning servomechanism operable to position said module at any selectable one out of a plurality of horizontal coordinates, where said plurality of spaced locations lies coincidently with some out of the plurality of locations defined by the crossings of said co-ordinates.

8. An apparatus according to any one of the preceding claims wherein said module comprises an arm and a gripper, said arm being operable to advance said gripper towards said dispensing ends of said dispensing runways and said gripper being operable to uplift a package therefrom.

9. An apparatus according to claim 8 when dependent upon claim 6 wherein said gripper comprises an upper jaw for engaging the top of said terminal package and a lower jaw for engaging the bottom of the body of said terminal package, where said lower jaw comprises a narrow section for passing between the adjacent walls of said U-Shaped sections to engage said terminal package intermediately between said sets of legs, and where said upper and lower jaws comprise mutually-cooperative parallel faces for tilting said package to clear said lug and said plate when said arm withdraws said gripper from said dispensing end.

10. An apparatus according to claim 2 and claims 3 to 9 when dependent upon claim 2 wherein each one of said plurality of receiving runways consists in the parallel association of a pair of side walls whereover a package can sit with one set of legs over each wall.

11. An apparatus according to claim 10 wherein said plurality of receiving runways are disposed in a regular rectangular array and wherein each plane of said array of receiving runways consists in the common parallel association of a plurality of said side walls.

12. An apparatus according to claim 11 wherein each of said side walls comprises a rounded tip for the deposition of said removed package thereon.

13. An apparatus according to claim 12 when dependent upon claim 9 wherein said upper jaw comprises a selectably operable air jet for blowing said package deposited on said rounded tip into said receiving runway.

14. An apparatus according to claims 4 to 13 wherein said U-Shaped sections are adapted to receive a package-containing stick to sit astride said adjacent walls and dispense packages held therein onto said dispensing runway.

15. An apparatus according to claims 10 to 14 wherein said side walls are spaced to allow the sitting astride thereover of a package-receiving stick for receiving packages dispensed into said receiving runway by said module.

16. An apparatus according to any of the preceding claims operable to provide indication of from which one cut of said plurality of dispensing runways said module is in the act of removing a package and indication of the type of package being so removed.

**Patentansprüche**

1. Vorrichtung zum Zusammenbauen einer seriellen Reihe verschiedener Typen integrierter Schaltkreis-Baueinheiten in einer geordneten Gruppe, gekennzeichnet durch mehrere Abgabe-Rutschbahnen, von denen jede eine serielle Reihe integrierter Schaltkreis-Baueinheiten an ihrem Empfangsende empfängt und die Baueinheiten an einem Abgabeende bereitstellt, wobei die mehreren Abgabe-Rutschbahnen so angeordnet sind, dass sie die entsprechenden mehreren Abgabeenden an entsprechend mehreren beabstandeten Stellen in einer zweiten Gruppierung vorlegen, einen Positionierer, ein Baueinheiten-Manipulierungsmodul und einen Zusammenbaupunkt, wobei der Positionierer das Modul in mehreren Rundfahrten zwischen dem Zusammenbaupunkt und einer gleich grossen Anzahl vorbestimmter Sequenzen zwischen den beabstandeten Stellen bewegt, und wobei das Modul die Baueinheit aus dem Abgabeende der Abgabe Rutschbahn in jeder der beabstandeten Stellen in der vorbestimmten Sequenz entnimmt und die entnommene Baueinheit am Zusammenbaupunkt bei jeder Gelegenheit, bei der sie dort ankommt, ablegt.

2. Vorrichtung nach Anspruch 1, dadurch gekennzeichnet, dass der Zusammenbaupunkt mehrere Empfangs-Rutschbahnen enthält und dass der Positionierer das Modul zwischen den Empfans-Rutschbahnen als Teil der vorbestimmten Sequenz der Auswahl einer unter den mehreren Empfangs-Rutschbahnen positioniert, damit das Modul die entnommene Baueinheit darin ablegt.

3. Vorrichtung nach Anspruch 2, dadurch gekennzeichnet, dass jede Abgabe-Rutschbahn unter einem Winkel gegenüber der Horizontalen angeordnet ist, damit die Schwerkraft die Baueinheitenreihe in Richtung des Abgabeendes bewegt, und dass jede der mehreren Empfangs-Rutschbahnen unter einem Winkel gegenüber der Horizontalen angeordnet ist, damit die empfangene Baueinheit unter Einwirkung der Schwerkraft von dem Punkt der Ablage durch das Modul bewegt wird.

4. Vorrichtung nach den Ansprüchen 1 bis 3, dadurch gekennzeichnet, dass jede der Abgabe-Rutschbahnen aus den parallelen unmittelbaren Verbindung zweier U-förmiger Kanäle besteht, auf deren benachbarten Wänden eine Baueinheit rittlings sitzt, wobei die beiden Anschlussbeinreihen der Baueinheit sich in jeweils einem Kanal befinden.

5. Vorrichtung nach Anspruch 4, dadurch gekennzeichnet, dass die mehreren beabstandeten Stellen eine regelmässige rechtwinklige Gruppierung bilden und dass jede Abgabe-Rutschbahnen-Ebene mehrere der U-förmigen Kanäle in gemeinsamer paralleler Verbindung enthält.

6. Vorrichtung nach Anspruch 5, dadurch gekennzeichnet, dass jede der Wände der U-förmigen Kanäle einen Anschlag, der den Austritt des Endstückes in der Baueinheitenreihe aus dem Abgabeende verhindert und eine Platte enthält, die einen schrägen Ausgang der End-Baueinheit unter der Schwerkraftwirkung der nachfolgenden Baueinheiten in der Reihe verhindert.

7. Vorrichtung nach einem der vorstehenden Ansprüche, dadurch gekennzeichnet, dass der Positionierer einen vertikalen Positionierungs-Servomechanismus enthält, der das Modul an einer wählbaren von mehreren vertikalen Koordinaten und einen horizontalen Positionierungs-Servomechanismus enthält, der das Modul an jeder wählbaren von mehreren horizontalen Koordinaten positioniert, wobei die mehreren beabstandeten Stellen koinzident zu einigen der mehreren Stellen, die durch die Kreuzung der Koordinaten gebildet werden, liegen.

8. Vorrichtung nach einem der vorstehenden Ansprüche, dadurch gekennzeichnet, dass das Modul einen Arm und einen Greifer enthält, wobei der Arm den Greifer in Richtung auf die Abgabeenden der Abgabe-Rutschbahnen vortreibt und der Greifer eine Baueinheit daraus emporhebt.

9. Vorrichtung nach Anspruch 8 in Abhängigkeit von Anspruch 6, dadurch gekennzeichnet, dass der Greifer eine obere Klaue, die die Oberseite der End-Baueinheit erfasst und eine untere Klaue enthält, die den Boden des Körpers der End-Baueinheit erfasst, wobei die untere Klaue einen engen Abschnitt enthält, der zwischen die benachbarten Wände der U-förmigen Abschnitte fährt, um die End-Baueinheit zwischen den Anschlussbeinreihen zu erfassen, und wobei die obere und untere Klaue gegenseitig kooperierende parallele Flächen aufweisen, um die Baueinheit zu kippen, um sie bezüglich des Anschlages und der Platte freizulegen, wenn der Arm den Greifer von dem Abgabeende wegzieht.

10. Vorrichtung nach Anspruch 2 und den Ansprüchen 3 bis 9 in Abhängigkeit von Anspruch 2, dadurch gekennzeichnet, dass jede der mehreren Empfangs-Rutschbahnen aus der parallelen Verbindung zweier Seitenwände besteht, über die eine Baueinheit gleiten kann, wobei jeweils eine Anschlussbeinreihe über jede Wand ragt.

11. Vorrichtung nach Anspruch 10, dadurch gekennzeichnet, dass die mehreren Empfangs-Rutschbahnen in einer regelmässig rechtwinkligen Gruppierung angeordnet sind, und dass jede Ebene der Gruppierung von Empfangs-Rutschbahnen aus der gemeinsamen parallelen Verbindung mehrerer der Seitenwände besteht.

12. Vorrichtung nach Anspruch 11, dadurch gekennzeichnet, dass jede der Seitenwände eine gerundete Spitze auf Ablage der entnommenen Baueinheit aufweist.

13. Vorrichtung nach Anspruch 12 in Abhängigkeit von Anspruch 9, dadurch gekennzeichnet, dass die obere Klaue eine wahlweise betätigbare Luftdüse aufweist, mit der die auf der gerundeten Spitze abgelegte Baueinheit in die Empfangs-Rutschbahn geblasen wird.

14. Vorrichtung nach den Ansprüchen 4 bis 13, dadurch gekennzeichnet, dass die U-förmigen Abschnitte eine eine Baueinheit enthaltende Stützvorrichtung aufnehmen, die rittlings über den benachbarten Wänden sitzt und darin auf die Abgabe-Rutschbahn abzugebende Baueinheiten hält.

15. Vorrichtung nach den Ansprüchen 10 bis 14, dadurch gekennzeichnet, dass die Seitenwände beabstandet sind, um ein Rittlingssitzen einer eine Baueinheit aufnehmenden Stützvorrichtung zu gestatten, die Baueinheiten aufnimmt, die in die Empfangs-Rutschbahn mittels des Moduls abgegeben werden.

16. Vorrichtung nach einem der vorstehenden Ansprüche, dadurch gekennzeichnet, dass eine Anzeigevorrichtung vorgesehen ist, die angibt, aus welcher der mehreren Abgabe-Rutschbahnen das Modul gerade eine Baueinheit entnimmt und die den Typ der entfernten Baueinheit anzeigt.

## Revendications

1. Appareil pour assembler une file en série de types différents de boîtiers de circuits intégrés dans un ensemble ordonné, cet appareil étant caractérisé en ce qu'il comprend un ensemble de chemins de distribution, chacun pour recevoir une file en série de boîtiers de circuits intégrés à une extrémité de réception et pour rendre ces boîtiers disponibles à une extrémité de distribution, cet ensemble de chemins de distribution étant disposé de façon à présenter l'ensemble correspondant des extrémités de distribution à un ensemble correspondant d'endroits espacés répartis dans un réseau à deux dimensions, cet appareil comportant en outre un dispositif de positionnement, un module de manipulation de boîtiers et un point d'assemblage, le dispositif de positionnement pouvant être mis en oeuvre pour déplacer le module dans un ensemble de boucles entre le point d'assemblage et une séquence prédéterminée de même nombre entre les positions espacées, et le module pouvant être mis en oeuvre pour enlever un boîtier de l'extrémité de distribution du chemin de distribution dans chacun des endroits espacés suivant une séquence prédéterminée et à déposer le boîtier enlevé au point d'assemblage lors de chaque arrivée à celui-ci.

2. Appareil selon la revendication 1, caractérisé en ce que le point d'assemblage se compose d'un ensemble de chemins de réception et le dispositif de positionnement peut être mis en oeuvre pour positionner le module parmi les chemins de réception comme partie de la séquence prédéterminée pour choisir l'un des différents chemins de réception pour le module, pour déposer le boîtier qui a été enlevé.

3. Appareil selon la revendication 2, caractérisé en ce que chacun des chemins de distribution est disposé suivant un angle par rapport à la direction horizontale pour que les forces de gravité poussent la file de boîtiers vers l'extrémité de distribution et chacun des ensembles de chemins de réception est disposé suivant un angle par rapport à la direction horizontale pour que le boîtier reçu soit poussé par gravité pour être écarté du point de dépôt par le module.

4. Appareil selon les revendications 1 à 3, caractérisé en ce que les chemins de distribution sont constitués par la réunion sensiblement parallèle de deux canaux à section en U, le boîtier reposant à cheval sur les parois adjacentes de ceux-ci, les deux ensembles de pattes étant dans chaque canal.

5. Appareil selon la revendication 4, caractérisé en ce que l'ensemble de positions éloignées forme un réseau rectangulaire régulier et chaque plan des chemins de distribution se compose d'un ensemble de canaux à section en U réunis en commun en parallèle.

6. Appareil selon la revendication 5, caractérisé en ce chacune des parois des canaux à section en U comporte une patte pour éviter la sortie du boîtier d'extrémité de la file de boîtiers à l'extrémité de distribution ainsi qu'une plaque pour éviter le basculement en éjection du boîtier d'extrémité sous l'effet de la force de gravité exercée par les autres boîtiers de la file.

7. Appareil selon l'une quelconque des revendications précédentes, caractérisé en ce que le dispositif de positionnement comporte un servomécanisme de positionnement vertical permettant de positionner le module suivant n'importe quelle coordonnée verticale choisie parmi un ensemble de coordonnées verticales et un servomécanisme de positionnement horizontal pour positionner le module à l'une quelconque des coordonnées horizontales parmi un ensemble de coordonnées horizontales, l'ensemble de positions espacées étant situé en coïncidence avec certains des ensembles de positions définis par l'intersection des coordonnées.

8. Appareil selon l'une quelconque des revendications précédentes, caractérisé en ce que le module comporte un bras et un organe de prise, le bras pouvant être mis en oeuvre pour faire avancer l'organe de prise vers les extrémités de distribution des chemins de distribution et l'organe de prise pouvant être mis en oeuvre pour y rendre un boîtier.

9. Appareil selon la revendication 8 prises en dépendance avec la revendication 6, caractérisé en ce que l'organe de prise se compose d'une mâchoire supérieure pour venir contre la partie supérieure du boîtier d'extrémité et une mâchoire inférieure pour venir en prise contre le fond du corps de boîtier d'extrémité, la mâchoire inférieure ayant une section étroite pour passer entre les parois adjacentes des parties à section en U et rencontrer le boîtier d'extrémitè entre les jeux de pattes, et la mâchoire supérieure et la mâchoire inférieure présentent des faces parallèles qui coopèrent réciproquement pour faire basculer le boîtier et dégager les pattes et la plaque lorsque le bras commande le retrait de l'organe de prise par rapport à l'extrémité de distribution.

10. Appareil selon la revendication 2 et les revendications 3 à 9 prises en dépendance avec la revendication 2, chacun des différents chemins de réception se composant de l'association en parallèle d'une paire de parois latérales sur lesquelles peut reposer un boîtier avec un jeu de pattes pardessus chaque paroi.

11. Appareil selon la revendication 10, caractérisé en ce que l'ensemble des chemins de réception est réparti suivant un réseau rectangulaire régulier et chaque plan du réseau de chemins de réception se compose de l'association en parallèle, en commun d'un ensemble de parois latérales.

12. Appareil selon la revendication 11, caractérisé en ce que chacune des parois latérales comporte une extrémité arrondie pour déposer le boîtier enlevé.

13. Appareil selon la revendication 12 prise en dépendance avec la revendication 9, caractérisé en ce que la mâchoire supérieure comporte une buse d'air à commande sélective pour souffler le boîtier déposé sur l'extrémité arrondie dans le chemin de réception.

14. Appareil selon la revendications 4 à 13, caractérisé en ce que les parties à section en U sont susceptibles de recevoir une colonne contenant des boîtiers pour reposer à cheval sur les parois adjacentes et distribuer les boîtiers qui sont retenus sur le chemin de distribution.

15. Appareil selon la revendication 10 à 14, caractérisé en ce que les parois latérales sont écartées pour permettre d'y mettre à cheval une colonne de réception de boîtiers pour recevoir les boîtiers distribués par le module à ce chemin de réception.

16. Appareil selon l'une quelconque des revendications précédentes, caractérisé en ce qu'il est mis en oeuvre pour fournir une indication sur celui des différents chemins de distribution avec lequel coopère le module pour enlever un boîtier et pour indiquer le type de boîtier qui est ainsi enlevé.

FIG.1

# FIG.2

# FIG.3

FIG.4

FIG.5

FIG.6

SN7400N

# FIG.7

# FIG.8

FIG.9A

FIG.9B

FIG.10

FIG.11

# FIG.12

Flowchart:

ENTER STICK NAME & NUMBER(N) REQUIRED → MANUAL START → PRINT N+1 LABELS → SEND MODULE "HOME"

SEND MODULE "HOME" → HOME? — NO (loops back) / YES → CALL OUT X & Y COORDINATES OF PACKAGE → CALL OUT & DISPLAY PART NUMBER & LIGHT LED → SEND MODULE TO X & Y

SEND MODULE TO X & Y → ARRIVED? — NO (loops back) / YES → PICK UP PACKAGE

ARRIVED? — NO → MANUAL RESTART? — YES (to PICK UP PACKAGE) / NO → FREEZE & ILLUMINATE ALARM LIGHT — 152

FREEZE & ILLUMINATE ALARM LIGHT ← SUCCESS? — NO

PICK UP PACKAGE → SUCCESS? — YES → CALL OUT APPROPRIATE TEST STATION

CALL OUT APPROPRIATE TEST STATION → MOVE MODULE TO TEST STATION → PLACE PACKAGE IN TEST STATION → PASS TEST?

PASS TEST? — NO → PLACE PACKAGE IN DISCARD STICK

PASS TEST? — YES → PLACE PACKAGE IN NAMED STICK → CALL OUT NEXT PACKAGE → DONE? — NO (loops back) / YES → STOP